# EUROPÄISCHE PATENTSCHRIFT

(11) **EP 2 593 526 B1**
(45) Veröffentlichungstag und Bekanntmachung des Hinweises auf die Patenterteilung: **11.02.2015**
(21) Anmeldenummer: 11745714.3
(22) Anmeldetag: 08.07.2011
(51) Int. Cl.: C09K 11/61, C09K 11/59, C09K 11/62, H01L 33/50

(54) **OPTOELEKTRONISCHES BAUELEMENT**
OPTOELECTRONIC COMPONENT
COMPOSANT OPTO-ÉLECTRONIQUE

(30) Priorität: 12.07.2010 DE 102010031237
(43) Veröffentlichungstag der Anmeldung: 22.05.2013
(73) Patentinhaber: OSRAM Opto Semiconductors GmbH, 93055 Regensburg (DE)
(72) Erfinder: GROSSE, Kristin, 93055 Regensburg (DE); BAADE, Torsten, 93059 Regensburg (DE)
(74) Vertreter: Epping - Hermann - Fischer
(86) Internationale Anmeldenummer: PCT/EP2011/061589
(87) Internationale Veröffentlichungsnummer: WO 2012/007369

(56) Entgegenhaltungen:
- US-A1- 2009 152 576
- US-A1- 2010 164 365
- YOUNG RAG DO ET AL: "Luminescence Properties of Potential Sr[sub 1-x]Ca[sub x]Ga[sub 2]S[sub 4]:Eu Green- and Greenish-Yellow-Emitting Phosphors for White LED", JOURNAL OF THE ELECTROCHEMICAL SOCIETY, Bd. 153, Nr. 7, 1. Januar 2006 (2006-01-01), Seite H142, XP55010032, ISSN: 0013-4651, DOI: 10.1149/1.2200299

## Beschreibung

Die vorliegende Erfindung betrifft ein optoelektronisches Bauelement mit einem Halbleiterchip zum Emittieren von elektromagnetischer Strahlung und einen Leuchtstoff zur Wellenlängenkonversion.

Aus dem Stand der Technik sind optoelektronische Bauelemente mit Halbleiterchips bekannt, die elektromagnetische Strahlung im blauen Spektralbereich mit einer Wellenlänge kleiner etwa 480 nm emittieren. Um hohe Lumenwerte zu erreichen, müssen die Halbleiterchips möglichst langwellige elektromagnetische Strahlung emittieren. Dies hat den Nachteil, dass mit steigender Wellenlänge die Strahlungsleistung eines im blauen Spektralbereich emittierenden Halbleiterchips stark abnimmt.

Aufgabe der Erfindung ist es, ein optoelektronisches Bauelement anzugeben, das Halbleiterchips mit einer hohen Strahlungsleistung beinhaltet und gleichzeitig Licht im langwelligen blauen Spektralbereich emittiert.

Diese Aufgabe wird gelöst durch ein optoelektronisches Bauelement gemäß dem Patentanspruch 1.

Weiterbildungen und vorteilhafte Ausgestaltungen des optoelektronischen Bauelements sind in den abhängigen Ansprüchen angegeben.

### Beispielhafte Ausführungsformen

Verschiedene Ausführungsformen weisen ein optoelektronisches Bauelement mit einem Träger und mit mindestens einem Halbleiterchip auf.

Der Halbleiterchip ist zumindest teilweise von einem Leuchtstoff umgeben. Der Halbleiterchip emittiert eine Primärstrahlung im kurzwelligen blauen Spektralbereich bei einer Dominantwellenlänge von kleiner etwa 465 nm. Der erfindungsgemäße Leuchtstoff wandelt zumindest einen Teil der Primärstrahlung in eine längerwellige Sekundärstrahlung im grünen Spektralbereich bei einer Dominantwellenlänge zwischen etwa 490 nm und etwa 550 nm. Dadurch entsteht Mischlicht aus Primärstrahlung und Sekundärstrahlung bei einer Dominantwellenlänge zwischen etwa 460 nm und etwa 480 nm. Der Lichtstrom des Mischlichts ist um bis zu 130 % größer als der Lichtstrom bei einem optoelektronischen Bauelement ohne Leuchtstoff mit gleicher Dominantwellenlänge im Bereich zwischen 460 nm und 480nm, d.h. im langwelligen blauen Spektralbereich.

In einer bevorzugten Ausführungsform liegen die Farborte des Mischlichts aus der vom Halbleiterchip emittierten Primärstrahlung mit einer Dominantwellenlänge im Bereich von etwa 440 nm bis etwa 455 nm und aus vom Leuchtstoff ausgehenden Sekundärstrahlung mit einer Dominantwellenlänge im Bereich von etwa 490 nm bis etwa 550 nm im CIE-Diagramm (100) so nahe beieinander, dass bei einheitlicher Leuchtstoffkonzentration die Dominantwellenlängen des Mischlichts innerhalb eines Wellenlängenbereichs von etwa 2 nm bis 4 nm, insbesondere 3 nm, liegen. Dies ist besonders vorteilhaft, da dadurch die Produktionsverteilung im CIE-Farbraum bei Verwendung von kurzwelligen (440nm bis 455nm) Halbleiterchips eine kleinere Fläche überstreicht als bei Produktion von längerwelligen Halbleiterchips. Dies führt dazu, dass bei Kombination der gesamten Produktion kurzwelliger blau emittierender Halbleiterchips mit dem verwendeten Leuchtstoff eine kleinere Dominantwellenverteilung erzeugbar ist, als dies bei der Produktion längerwelliger, blau emittierender Halbleiterchips möglich ist. Die Verkleinerung des Dominantwellenlängenbereichs der produzierten Halbleiterchips führt zu einem gleichmäßigeren Erscheinungsbild der von den optoelektronischen Bauelementen emittierten Strahlung. Durch die Verwendung des Leuchtstoffes lässt sich die Verteilung der Dominantwellenlänge noch weiter verkleinern. Der verwendete Leuchtstoff lässt sich umso effizienter anregen, umso kurzwelliger die Anregungswellenlänge ist. Dies hat insgesamt zur Folge, dass ein deutlich größerer Anteil einer Chipproduktion in einer Anwendung verbaut werden kann. Die Chipausbeute steigt und die Kosten sinken.

In einer bevorzugten Ausführungsform des optoelektronischen Bauelements liegt der Farbort des optoelektronischen Bauelements, das Mischlicht emittiert, im CIE-Diagramm auf den durch die verschiedenen Blaunormen, insbesondere EN 12966 C1 (VMS) und EN 12966 C2 (VMS), aufgespannten Flächen.

In einer bevorzugten Ausführungsform des optoelektronischen Bauelements ist der Leuchtstoff in Form von Partikeln in einem Verguss verteilt. Dies ist besonders vorteilhaft, da dies bei der Herstellung durch ein besonders einfaches Verfahren erreicht werden kann. Damit können die Herstellungskosten niedrig gehalten werden. Der Leuchtstoff liegt im Verguss vorzugsweise in einer Konzentration kleiner 3 Gewichtsprozent vor. Besonders vorteilhaft beträgt die Leuchtstoffkonzentration 1,5 Gewichtsprozent.

In einer bevorzugten Ausführungsform des optoelektronischen Bauelements ist der Leuchtstoff in einem Plättchen angeordnet, das unmittelbar auf dem Halbleiterchip aufliegt. Mit anderen Worten handelt es sich um Chip-Level-Conversion (CLC).

In einer bevorzugten Ausführungsform ist der Leuchtstoff an oder in einem Austrittsfenster, das das optoelektronische Bauelement um den Halbleiterchip abschließt, angeordnet. Verschiedene Ausführungsformen zeigen ein optoelektronisches Bauelement, bei dem der Leuchtstoff ein Europium aktiviertes Blau-Grünes Silikat, insbesondere ein Chlorosilikat, aufweist. Der Leuchtstoff ist aus der Offenlegungsschrift DE10026435A1 bekannt. Der Chlorosilikat-Leuchtstoff weist neben der Dotierung mit Europium eine Dotierung mit Mangan auf. Es gilt die Summenformel Ca_{8-x-y}EuₓMn_{y}Mg (SiO₄)₄Cl₂ mit y≥0,03. Der Anteil des Europium liegt zwischen x=0,005 und x=1,5. Der Anteil des Mangan beträgt zwischen y=0,03 und y=1,0. Die Dominantwellenlänge der längerwelligen Sekundärstrahlung, die von obigem Leuchtstoff ausgeht, liegt im grünen Spektralbereich bei Wellenlängen zwischen 490 nm und 540 nm. Die Offenbarung der DE10026435A1 wird hiermit durch Rückbezug in die Offenbarung der vorliegenden Anmeldung aufgenommen.

Verschiedene Ausführungsformen zeigen ein optoelektronisches Bauelement, bei dem der Leuchtstoff Europium aktivierte Orthosilicate aufweist. Es gilt die Summenformel (Ca,Sr,Ba)₂SiO₄:EU. Die Dominantwellenlänge der längerwelligen Sekundärstrahlung, die von obigem Leuchtstoff ausgeht, liegt im grünen Spektralbereich bei größer 518 nm.

Verschiedene Ausführungsformen zeigen ein optoelektronisches Bauelement, bei dem der Leuchtstoff Europium aktivierte Thiogallate aufweist. Es gilt die Summenformel (Mg,Ca,Sr,Ba)Ga₂S₄:EU. Die Dominantwellenlänge der längerwelligen Sekundärstrahlung, die von obigem Leuchtstoff ausgeht, liegt im grünen Spektralbereich.

Verschiedene Ausführungsformen zeigen ein optoelektronisches Bauelement, bei dem der Leuchtstoff Europium aktivierte SiONe aufweist. Es gilt die Summenformel Ba₃Si₆O₁₂N₂:EU. Die Dominantwellenlänge der längerwelligen Sekundärstrahlung, die von obigem Leuchtstoff ausgeht, liegt im grünen Spektralbereich bei etwa 540 nm.

Verschiedene Ausführungsformen zeigen ein optoelektronisches Bauelement, bei dem der Leuchtstoff beta-SiAlON aufweist. Die Dominantwellenlänge der längerwelligen Sekundärstrahlung, die von obigem Leuchtstoff ausgeht, liegt im grünen Spektralbereich.

Verschiedene Ausführungsformen zeigen ein optoelektronisches Bauelement bei dem der Leuchtstoff eine beliebige Kombination aus obigen Leuchtstofftypen aufweist.

In einer bevorzugten Ausführungsform weisen die erfindungsgemäßen Leuchtstoffe eine Quanteneffizienz von bis zu 70% auf. Dies ist besonders vorteilhaft, da dadurch nur ein geringer Teil der Primärstrahlung durch Wechselwirkung mit dem Leuchtstoff in störende Wärme umgewandelt wird.

### KURZE BESCHREIBUNG DER ZEICHNUNGEN

Verschiedene Ausführungsbeispiele der erfindungsgemäßen Lösung werden im Folgenden anhand der Zeichnungen näher erläutert.
- Figur 1a: zeigt ein optoelektronisches Bauelement mit Volumenkonversion.
- Figur 1b: zeigt ein optoelektronisches Bauelement mit chipnaher Konversion.
- Figur 1c: zeigt ein optoelektronisches Bauelement mit Konversion am oder im Austrittsfenster.
- Figur 2a: zeigt eine simulierte Referenzsituation mit der Lage von Farborten verschiedener blau emittierender Halbleiterchips im CIE-Diagramm.
- Figur 2b: zeigt tabellarisch eine Simulation der Helligkeit und des Farborts der blau emittierenden Halbleiterchips aus Figur 2a.
- Figur 3a: zeigt eine simulierte Situation mit Lage von Farborten verschiedener blau emittierender Halbleiterchips im CIE-Diagramm nach einer Wellenlängenkonversion.
- Figur 3b: zeigt tabellarisch Ergebnisse der Simulation aus Figur 3a.
- Figur 4a: zeigt gemessene Farborte blau emittierender Halbleiterchips nach einer Wellenlängenkonversion für verschiedene Leuchtstoffkonzentrationen.
- Figur 4b: zeigt tabellarisch Messwerte zu Figur 4a.
- Figur 5a: zeigt gemessene Farborte blau emittierender Halbleiterchips bei einer Leuchtstoffkonzentration von 1%.
- Figur 5b: zeigt gemessene Farborte blau emittierender Halbleiterchips bei einer Leuchtstoffkonzentration von 1,5%.
- Figur 5c: zeigt gemessene Farborte blau emittierender Halbleiterchips bei einer Leuchtstoffkonzentration von 2%.

### AUSFÜHRUNGSBEISPIELE

Gleiche, gleichartige oder gleich wirkende Elemente sind in den Figuren mit denselben Bezugszeichen versehen. Die Figuren und die Größenverhältnisse der in den Figuren dargestellten Elemente untereinander sind nicht als maßstäblich zu betrachten. Vielmehr können einzelne Elemente zur besseren Darstellbarkeit und zum besseren Verständnis übertrieben groß oder verkleinert dargestellt sein.

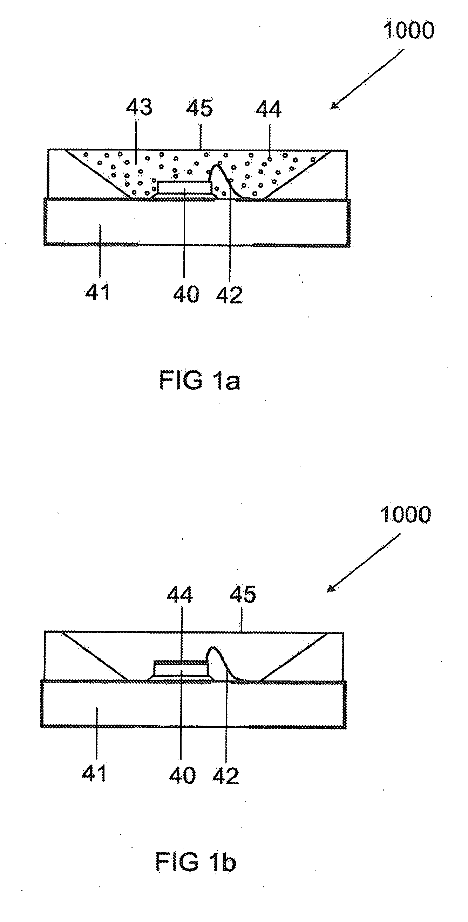

Figur 1a zeigt ein optoelektronisches Bauelement 1000 mit Volumenkonversion. Das optoelektronische Bauelement weist einen Halbleiterchip 40 auf. Der Halbleiterchip 40 kann auf einem III-V-Verbindungshalbleitermaterial basieren. Der Halbleiterchip 40 weist mindestens eine aktive Zone auf, die elektromagnetische Strahlung emittiert. Die aktiven Zonen können pn-Übergänge, Doppelheterostruktur, Mehrfach-Quantentopfstruktur (MQW), Einfach-Quantentopfstruktur (SQW) sein. Quantentopfstruktur bedeutet: Quantentöpfe (3-dim), Quantendrähte (2-dim) und Quantenpunkte (1-dim). Der Halbleiterchip 40 kann beispielsweise als Oberflächenemitter, insbesondere als sogenannter Dünnfilmchip, als Volumenemitter, insbesondere als Saphir-Volumenemitter, oder als sogenannter UX-3-Chip (Produktbezeichnung von OSRAM) ausgelegt sein.

Der Dünnfilmchip ist beispielsweise aus der Offenlegungsschrift WO2005081319A1 bekannt. Wird während der Herstellung des optoelektronischen Bauelements, insbesondere eines Bauelements mit einer metallhaltigen Spiegelschicht, das Aufwachssubstrat der Halbleiterschichtenfolge abgelöst, so werden derartige unter Ablösen des Aufwachssubstrats hergestellte Bauelemente auch als Dünnfilm-Bauelemente bezeichnet. Das strahlungsemittierende Halbleiterbauelement weist hierin einen Stapel unterschiedlicher III-V-Nitrid-Halbleiterschichten, insbesondere Galliumnitrid-Schichten, auf. Das Dünnschichtbauelement ist ohne strahlungsabsorbierendes Substrat ausgeführt und ein Reflektor ist direkt auf dem GaN-Halbleiterkörper aus dem Stapel unterschiedlicher III-V-Nitrid-Halbleiterschichten aufgebracht.

Der Saphir-Volumen-Emitter ist beispielsweise aus der Patentschrift DE102006015788A1 bekannt. Dabei kann als Aufwachssubstrat für die Halbleiterschichtenfolge Saphir verwendet werden. Im Gegensatz zum Dünnfilmchip wird beim Saphir-Volumen-Emitter das Aufwachssubstrat am Ende des Herstellungsprozesses nicht von der Halbleiterschichtenfolge abgelöst. Das (Aufwachs-)Substrat ist strahlungsdurchlässig für die in der aktiven Zone erzeugte Strahlung. Dies erleichtert die Strahlungsauskopplung aus dem Halbleiterchip durch das Substrat. Der Halbleiterchip ist damit als Volumenstrahler ausgebildet. Bei einem Volumenstrahler wird im Gegensatz zu einem Oberflächenemitter auch über das Substrat ein maßgeblicher Strahlungsanteil aus dem Halbleiterchip ausgekoppelt. Die Oberflächenleuchtdichte an den Auskoppelflächen des Halbleiterchips ist bei einem Volumenstrahler gegenüber einem Oberflächenstrahler verringert.

Der sogenannte UX-3-Chip ist aus der Offenlegungsschrift DE102007022947A1 bekannt. Darin wird ein optoelektronischer Halbleiterkörper mit einer Halbleiterschichtenfolge beschrieben, die eine aktive Schicht, eine erste und eine zweite elektrische Anschlussschicht aufweist. Der Halbleiterkörper ist zur Emission elektromagnetischer Strahlung von einer Vorderseite vorgesehen. Erste und zweite elektrische Anschlussschicht sind an einer der Vorderseite gegenüberliegenden Rückseite angeordnet. Sie sind mittels einer Trennschicht elektrisch gegeneinander isoliert. Die erste elektrische Anschlussschicht, die zweite elektrische Anschlussschicht und die Trennschicht können lateral überlappen. Ein Teilbereich der zweiten elektrischen Anschlussschicht erstreckt sich von der Rückseite durch einen Durchbruch der aktiven Schicht hindurch in Richtung zu der Vorderseite hin. Vorteilhaft an dem sogenannten UX-3-Chip ist es, dass im Gegensatz zum Dünnfilmchip an der Vorderseite der Halbleiterschichtenfolge kein Metall mehr angeordnet ist. Dadurch werden Absorptionsverluste vermieden.

Die Offenbarungen der Schriften WO2005081319A1, DE102006015788A1 und DE102007022947A1 werden hiermit durch Rückbezug in die Offenbarung der vorliegenden Anmeldung aufgenommen.

Der Halbleiterchip 40 mit einer Emissionswellenlänge im blauen Spektralbereich ist auf einem Träger 41 angeordnet und mittels eines Bonddrahtes 42 kontaktiert. Der Träger 41 kann exemplarisch als sogenannter Premold-Leadframe ausgebildet sein. Premold bedeutet, dass die Form aufgespritzt wird.

In einer nichtgezeigten Ausführungsform sind mehrere Halbleiterchips 40 in dem optoelektronischen Bauelement angeordnet.

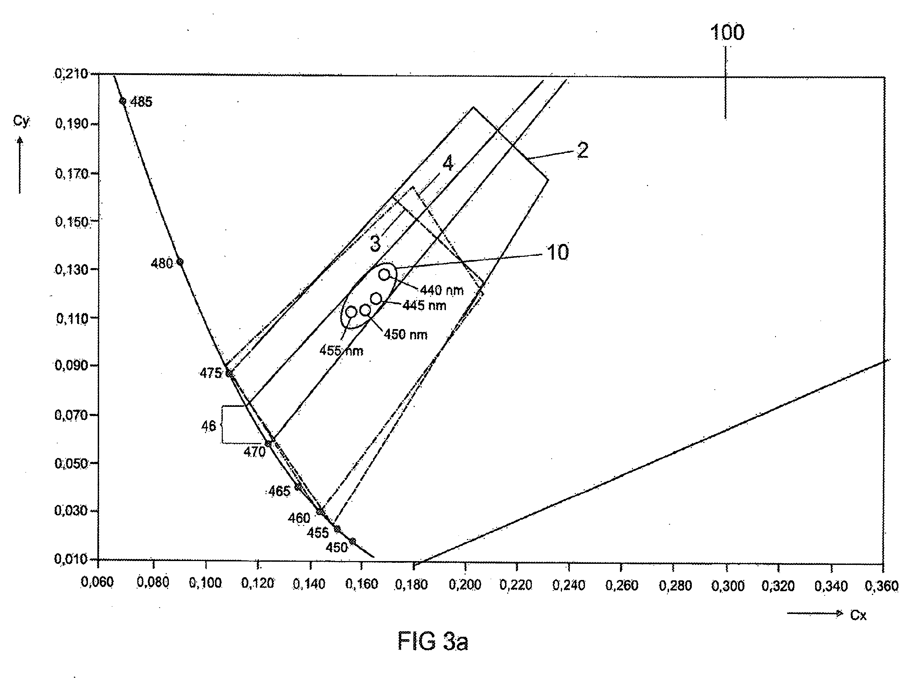

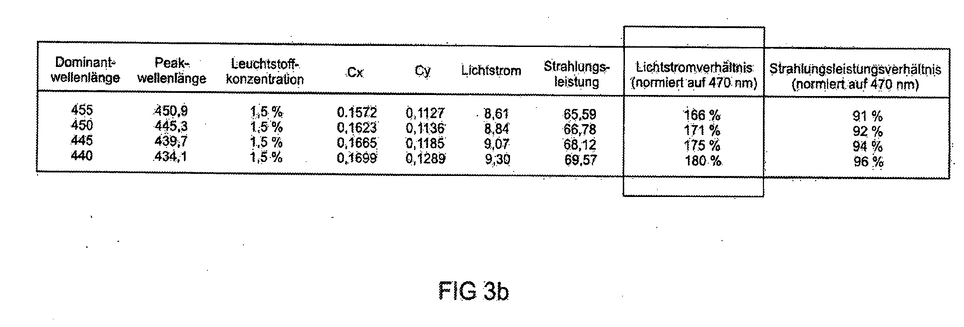

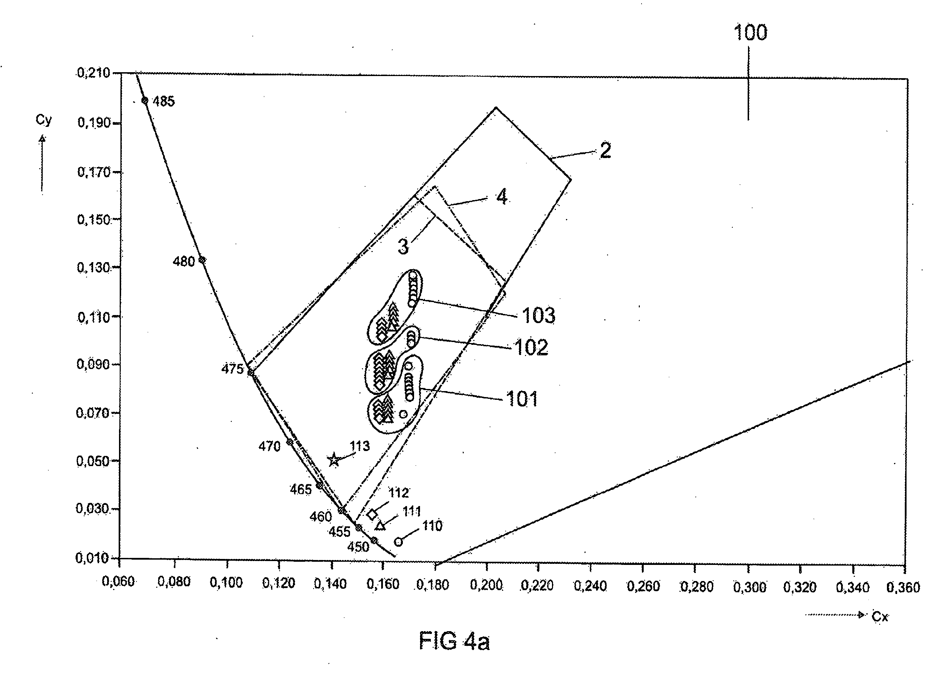

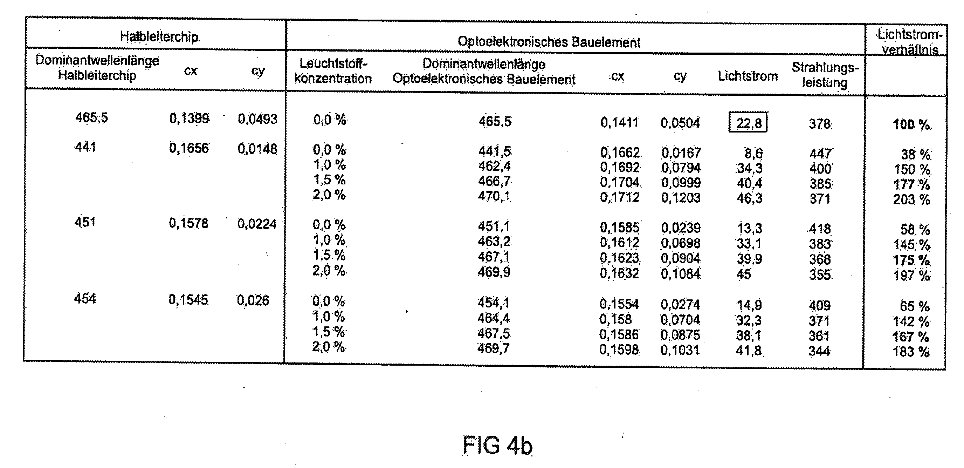

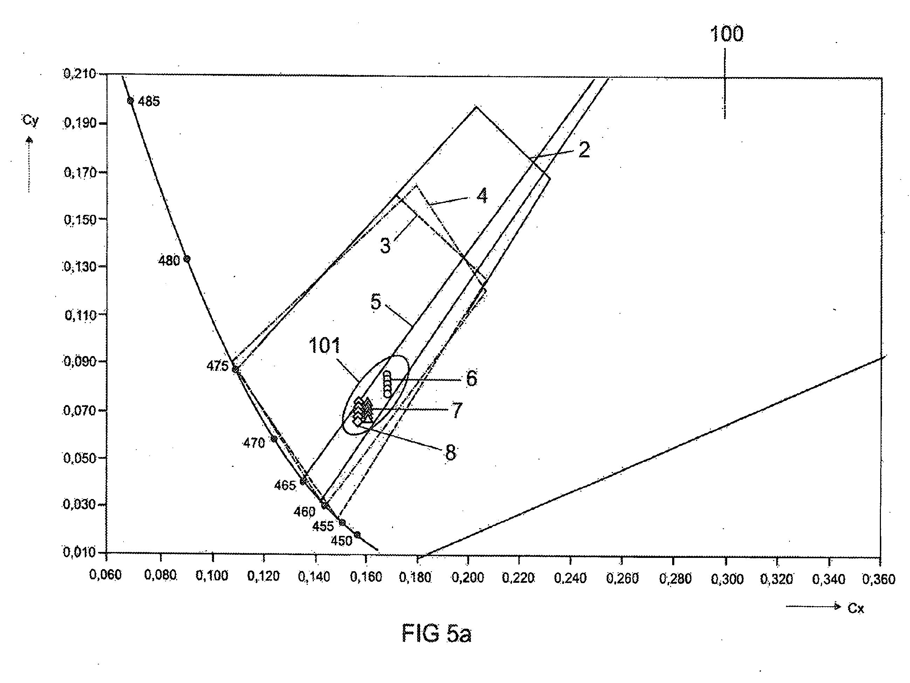

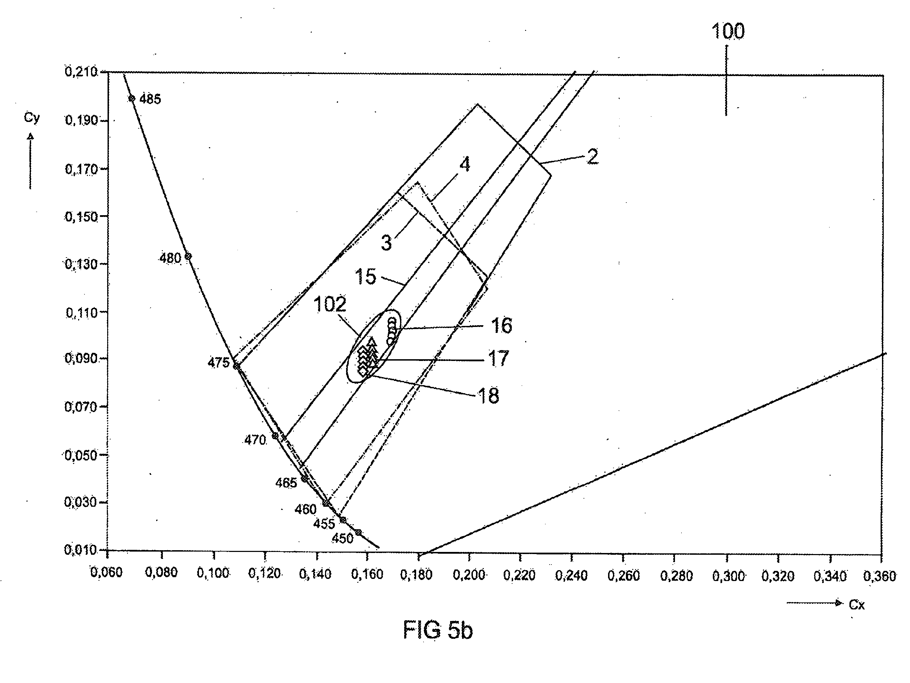

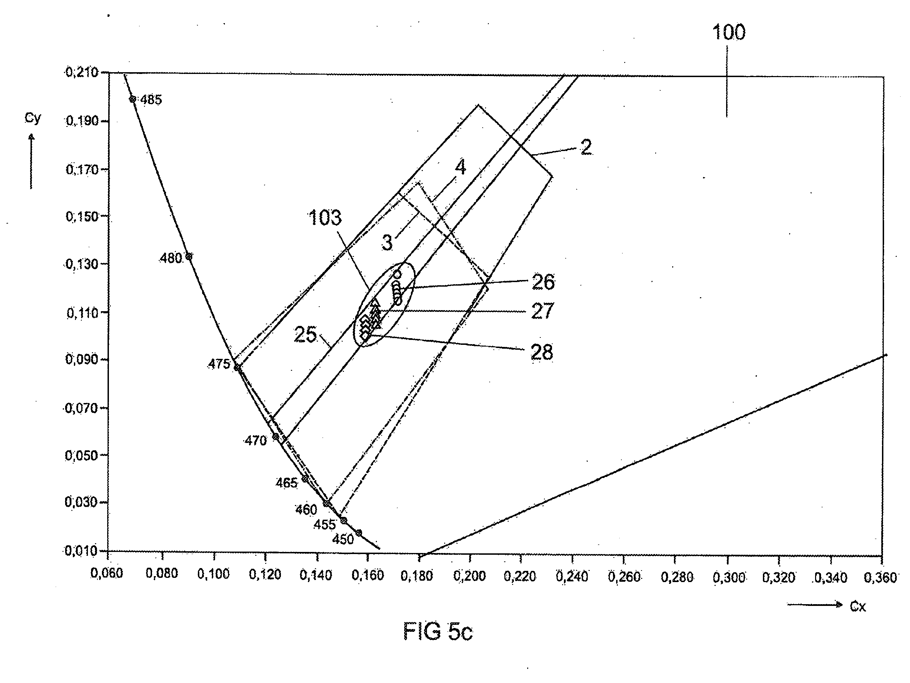

Der Leuchtstoff 44 ist in Form von Partikeln homogen in einem Verguss 43 verteilt. Die Simulation in Figur 3a und 3b und die Messungen in Figur 4a, 4b, 5a, 5b und 5c basieren auf einem optoelektronischen Bauelement mit einer homogenen Verteilung des Leuchtstoffs 44 im Verguss 43.

In nicht gezeigten Ausführungsbeispielen kann der Leuchtstoff teilweise oder vollständig sedimentiert sein. Durch die Sedimentation bildet sich am Boden des optoelektronischen Bauelements eine kontinuierliche Leuchtstoffschicht, die unter anderem auch den Halbleiterchip bedeckt. Hierzu werden in der vorliegenden Anmeldung keine Simulationen oder Messungen gezeigt.

Figur 1b zeigt ein optoelektronisches Bauelement 1000 mit Chipnaher Konversion, was als Chip Level Conversion (CLC) bezeichnet wird. Im Gegensatz zu Figur 1a ist der Leuchtstoff 44 in Form eines Plättchens unmittelbar auf dem Halbleiterchip 40 angeordnet. Der Träger 41 ist als sogenannter Premold-Leadframe ausgebildet. In einem nicht gezeigten Ausführungsbeispiel kann statt des Leuchtstoffplättchens eine Leuchtstoffschicht elektrophoretisch abgeschieden werden.

Diese Schicht bedeckt unter anderem auch den Halbleiterchip 40 und den Leadframe 41. Hierzu werden in der vorliegenden Anmeldung keine Simulationen oder Messungen gezeigt.

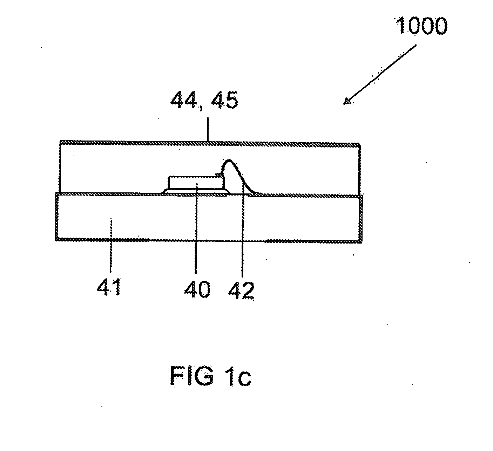

Figur 1c zeigt ein optoelektronisches Bauelement 1000 mit Konversion am Austrittsfenster 45. Als Leadframe eignet sich beispielsweise eine Keramik. Im Gegensatz zu Figur 1a und Figur 1b ist der Leuchtstoff in dem Austrittsfenster 45 oder an der Oberfläche des Austrittsfensters 45 angeordnet, was als Remote Phosphor bezeichnet wird. Das Austrittsfenster ist planar angeordnet. In einer nicht gezeigten Ausführungsform ist das Austrittsfenster hohlförmig oder kuppelförmig ausgebildet. Dieses Austrittsfenster ist an seiner Innenseite mit Leuchtstoff beschichtet. Der Leuchtstoff kann elektrophoretisch abgeschieden sein. Hierzu werden in der vorliegenden Anmeldung keine Simulationen oder Messungen gezeigt.

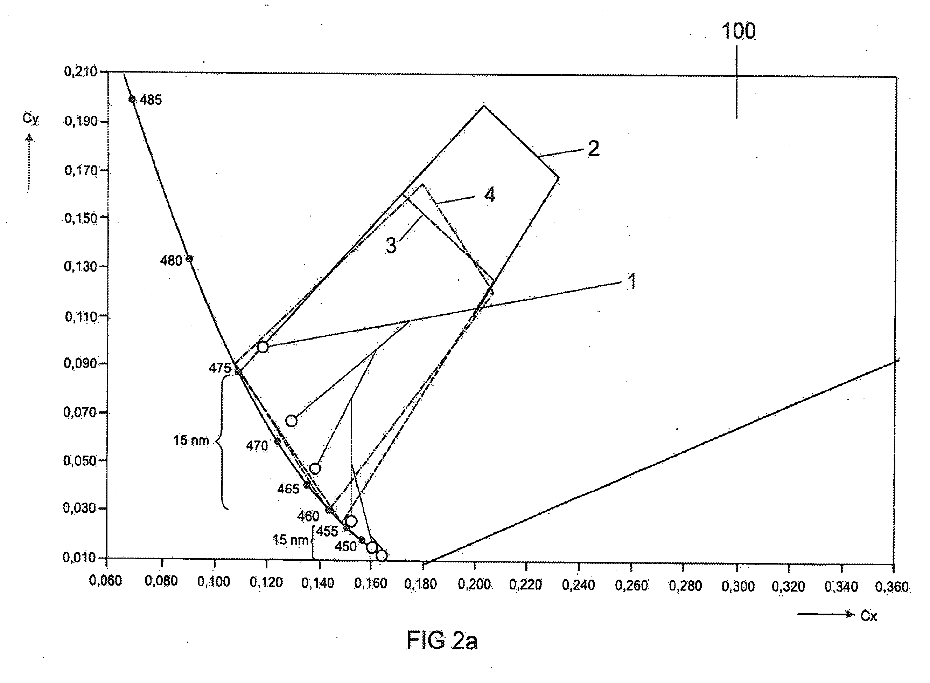

Figur 2a zeigt einen Ausschnitt 100 aus dem Farbraum gemäß CIE-Normfarbsystem. Vorliegend ist eine Referenzsituation dargestellt. Blau emittierende Halbleiterchips emittieren elektromagnetische Strahlung mit Dominantwellenlängen bei 440nm, 445nm, 455nm, 465nm, 470nm oder 475nm. Die Farborte 1 der blau emittierenden Halbleiterchips sind im CIE-Diagramm eingetragen. Nur die Halbleiterchips mit Dominantwellenlänge bei 465nm, 470nm und 475nm liegen innerhalb der Flächen 2, 3, 4 die von den Blaunormen EN 12966 C1, 12966 C2 und Rus Rail aufgespannt werden. Die außerhalb der Blaunormen liegenden Halbleiterchips mit Dominantwellenlänge bei 440nm, 445nm, 455nm können an sich nicht für Beleuchtungszwecke verwendet werden. Mit anderen Worten können Applikationen nicht den gesamten Produktionsbereich der Halbleiterchips akzeptieren. Die Farborte der Halbleiterchips liegen nahe an der Einhüllenden des Farbraums 100, was eine sehr hohe Farbsättigung, insbesondere größer 90%, bedingt.

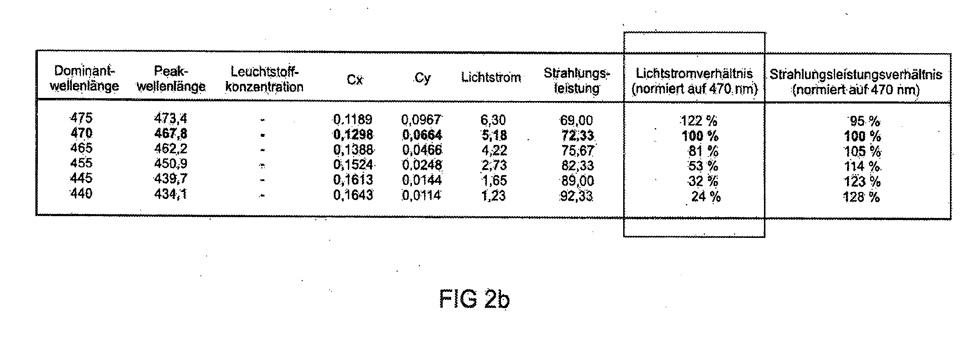

Figur 2b zeigt tabellarisch eine Simulation der Helligkeiten und der Farborte der blau emittierenden Halbleiterchips aus Figur 2a. Es wird kein Leuchtstoff verwendet. In der Tabelle sind Peakwellenlängen, Dominantwellenlängen, Orte der Halbleiterchips 1 im Farbraum an Hand der Koordinaten Cx und Cy, Lichtstrom, Strahlungsleistung, Lichtstromverhältnis normiert auf den Lichtstrom bei der Dominantwellenlänge 470 nm und das Strahlungsleistungsverhältnis normiert auf die Strahlungsleistung bei der Dominantwellenlänge 470 nm aufgeführt. Die Strahlungsleistung nimmt mit steigender Wellenlänge kontinuierlich ab, wohingegen der Lichtstrom, d.h. die Strahlungsleistung gewichtet mit der V(λ)-Kurve, mit steigender Wellenlänge kontinuierlich zunimmt. Die V(λ)-Kurve beschreibt die Empfindlichkeit des menschlichen Auges im Wellenlängenbereich von 380 nm bis 780 nm. Das Maximum von V(λ) liegt bei etwa 550 nm, also im grünen Spektralbereich. Peakwellenlänge ist die Wellenlänge bei der das elektromagnetische Spektrum ein Maximum aufweist. Die Dominantwellenlänge ergibt sich aus der Gewichtung eines nichtmonochromatischen Spektrums mit der Empfindlichkeit des menschlichen Auges. Die Strahlungsleistung ist die von einer Lichtquelle in den Raum abgestrahlte Energie. Die Einheit ist Watt. Der Lichtstrom ist proportional zur Strahlungsleistung gewichtet mit der V(λ)-Kurve. Die Einheit ist Lumen.

Figur 3a zeigt eine simulierte Situation mit Lage von Farborten 10 verschiedener blau emittierender Halbleiterchips im CIE-Diagramm nach einer Wellenlängenkonversion. Es sind Farborte für Halbleiterchips mit Dominantwellenlängen bei 440nm, 445nm, 450nm und 455nm dargestellt. Der erfindungsgemäße Leuchtstoff liegt in einer Konzentration von 1,5% im Volumenverguss vor. Die vom Halbleiterchip 40 emittierte Primärstrahlung liegt also im kurzwelligen blauen Spektralbereich bei einer Dominantwellenlänge von kleiner etwa 455 nm. Die Leuchtstoffpartikel wandeln zumindest einen Teil der Primärstrahlung in eine längerwellige Sekundärstrahlung im grünen Spektralbereich bei einer Dominantwellenlänge zwischen etwa 490 nm und etwa 550 nm. Das Mischlicht aus Primärstrahlung und Sekundärstrahlung weist eine Dominantwellenlänge bei Wellenlängen zwischen etwa 460 nm und etwa 480 nm auf. Der Lichtstrom des Mischlichts ist um bis zu 130 % größer als der Lichtstrom bei einem optoelektronischen Bauelement ohne Leuchtstoff 44 mit gleicher Dominantwellenlänge im Bereich zwischen 460 nm und 480nm.

Die Farborte des Mischlichts aus der vom Halbleiterchip 40 emittierten Primärstrahlung mit einer Dominantwellenlänge im Bereich von etwa 440 nm bis etwa 455 nm und aus vom Leuchtstoff 44 ausgehenden Sekundärstrahlung mit einer Dominantwellenlänge im Bereich von etwa 490 nm bis etwa 550 nm liegen im CIE-Diagramm (100) so nahe beieinander, dass bei einheitlicher Leuchtstoffkonzentration die Dominantwellenlängen des Mischlichts innerhalb eines projizierten Dominantwellenlängenbereichs 46 von etwa 2 bis 4 nm, insbesondere 3 nm, liegen. Dabei werden die Farborte der optoelektronischen Bauelemente auf die Einhüllende des CIE-Farbraum projiziert.

Der Farbort des optoelektronischen Bauelements (1000), das Mischlicht emittiert, liegt im CIE-Diagramm auf den durch die verschiedenen Blaunormen, insbesondere EN 12966 C1 (VMS) und EN 12966 C2 (VMS), aufgespannte Flächen. Die Farbsättigung liegt bei etwa 70%, was ein für die Wahrnehmung durch das menschliche Auge ausreichender Wert ist.

Figur 3b zeigt tabellarisch Ergebnisse der Simulation aus Figur 3a. Der Leuchtstoff 44 ist als in einem Verguss 43 verteilte Partikel vorgesehen und liegt in einer Konzentration von 1,5 Gewichtsprozent vor. Das Lichtstromverhältnis ist wiederum normiert auf den Lichtstrom bei 470 nm ohne Leuchtstoff. Der Wert für den Lichtstrom bei 470 nm beträgt 5,18 (siehe Figur 2b). Für die Dominantwellenlänge 455 nm beträgt die Steigerung des Lichtstroms 66%. Für die Dominantwellenlänge 440 nm beträgt die Steigerung des Lichtstroms sogar 80%.

Figur 4a zeigt gemessene Farborte blau emittierender Halbleiterchips nach einer Wellenlängenkonversion für verschiedene Leuchtstoffkonzentrationen.

Als Referenz ist der Farbort 110 eines Halbleiterchips mit einer Dominantwellenlänge von 441 nm, der Farbort 111 eines Halbleiterchips mit einer Dominantwellenlänge von 451 nm, der Farbort 112 eines Halbleiterchips mit einer Dominantwellenlänge von 454 nm und der Farbort 113 eines Halbleiterchips mit einer Dominantwellenlänge 465,5 nm aufgetragen. Es ist kein Leuchtstoff eingesetzt. Die Farborte 110, 111 und 112 liegen außerhalb der gültigen Blaunormen.

Es sind die Farborte für die Halbleiterchips bei einer Leuchtstoffkonzentration von 1% 101, 1,5% 102 und 2% 103 dargestellt. Trotz verwendeter Halbleiterchipwellenlänge aus einem Bereich von etwa 15 nm (441 nm bis 454 nm) liegen die Dominantwellenlängen der optoelektronischen Bauelemente bei einer einheitlichen Leuchtstoffkonzentration vorteilhafter Weise im Bereich von etwa 2 nm. In der Figur sind unter anderem Linien eingezeichnet, die auf die Einhüllende des CIE-Farbraums treffen. Farborte, die auf der gleichen Linie liegen, haben die gleiche Dominantwellenlänge.

Figur 4b zeigt tabellarisch Messwerte zu Figur 4a. Im ersten Abschnitt der Tabelle sind zu den Dominantwellenlängen der Halbleiterchips mit 441 nm, 451 nm und 454 nm die Koordinaten Cx und Cy im CIE-Farbraum angegeben. Als Referenz dient der Farbort 113 des Halbleiterchips mit einer Dominantwellenlänge von 465,5 nm. Im zweiten Abschnitt der Tabelle sind Messwerte zu den optoelektronischen Bauelementen, also zur Kombination von Halbleiterchip und Leuchtstoff, angegeben. Es werden Leuchtstoffkonzentrationen, die Dominantwellenlängen, Koordinaten der optoelektronischen Bauelemente im CIE-Farbraum und Stärken des von den optoelektronischen Bauelementen erzeugten Lichtstroms zueinander in Beziehung gesetzt. Zudem wird die Strahlungsleistung der optoelektronischen Bauelemente angegeben. Im dritten Abschnitt der Tabelle ist das Lichtstromverhältnis angegeben. Die Lichtströme der optoelektronischen Bauelemente sind hierzu auf den Lichtstrom eines Halbleiterchips mit einer Dominantwellenlänge von 465,5 nm ohne Einsatz eines Leuchtstoffes normiert. Der Lichtstrom auf den normiert wird beträgt 22,8 Lumen.

Exemplarisch sei die Situation mit optoelektronischen Bauelementen mit einer Leuchtstoffkonzentration von 1,5% erläutert. Die Dominantwellenlänge des ersten Halbleiterchips beträgt 441 nm, die zugehörige Dominantwellenlänge des optoelektronischen Bauelements, also der Kombination aus Halbleiterchip und Leuchtstoff, beträgt 466,7 nm. Der Lichtstrom beträgt 40,4 Lumen. Das Lichtstromverhältnis beträgt 177%. Dies bedeutet, dass der Lichtstrom um 77% größer ist, als beim Halbleiterchip mit einer Dominantwellenlänge von 465,5 nm und ohne Leuchtstoff. Die Dominantwellenlänge des zweiten Halbleiterchips beträgt 451 nm, die zugehörige Dominantwellenlänge des optoelektronischen Bauelements, also der Kombination aus Halbleiterchip und Leuchtstoff, beträgt 467,1 nm. Der Lichtstrom beträgt 39,9 Lumen. Das Lichtstromverhältnis beträgt 175%. Dies bedeutet, dass der Lichtstrom um 75% größer ist, als beim Halbleiterchip mit einer Dominantwellenlänge von 465,5 nm und ohne Leuchtstoff. Die Dominantwellenlänge des dritten Halbleiterchips beträgt 454 nm, die zugehörige Dominantwellenlänge des optoelektronischen Bauelements, also der Kombination aus Halbleiterchip und Leuchtstoff, beträgt 467,5 nm. Der Lichtstrom beträgt 38,1 Lumen. Das Lichtstromverhältnis beträgt 167%. Dies bedeutet, dass der Lichtstrom um 67% größer ist, als beim Halbleiterchip mit einer Dominantwellenlänge von 465,5 nm und ohne Leuchtstoff. Der Helligkeitsgewinn durch den Einsatz des Leuchtstoffes in einer Konzentration von 1,5% im Volumenverguss über dem Halbleiterchip beträgt bei einer Dominantwellenlänge im Bereich von 466 nm bis 468 nm demnach zwischen 67% und 77%.

Figur 5a zeigt einen Teilbereich der Figur 4a. Es sind die gemessenen Farborte blau emittierender Halbleiterchips 101 bei einer Leuchtstoffkonzentration von 1% aufgetragen. Es sind die Flächen 2, 3, 4 der oben genannten Blaunormen eingezeichnet. Es ist der gesamte Dominantwellenlängenbereich 5 der optoelektronischen Bauelemente bei 1% Leuchtstoffkonzentration in Form eines Segments aufgetragen. Es sind die Farborte 6 für eine Chipwellenlänge von 441 nm, die Farborte 7 für eine Chipwellenlänge von 451 nm und die Farborte 8 für eine Chipwellenlänge von 454 nm aufgetragen. Der Dominantwellenlängenbereich der optoelektronischen Bauelemente liegt zwischen 461 nm und 465 nm. Gemäß Figur 4b liegt der Lichtstrom oder mit anderen Worten die Helligkeit der optoelektronischen Bauelemente zwischen 32 Lumen und 34 Lumen bei einem elektrischen Strom von 350 mA.

Figur 5b zeigt einen Teilbereich der Figur 4a. Es sind die gemessenen Farborte blau emittierender Halbleiterchips 102 bei einer Leuchtstoffkonzentration von 1,5% aufgetragen. Es sind die Flächen 2, 3, 4 der Blaunormen eingezeichnet. Es ist der gesamte Dominantwellenlängenbereich 15 der optoelektronischen Bauelemente bei 1,5% Leuchtstoffkonzentration in Form eines Segments aufgetragen. Es sind die Farborte 16 für eine Chipwellenlänge von 441 nm, die Farborte 17 für eine Chipwellenlänge von 451 nm und die Farborte 18 für eine Chipwellenlänge von 454 nm aufgetragen. Der Dominantwellenlängenbereich der optoelektronischen Bauelemente liegt zwischen 466 nm und 469 nm. Gemäß Figur 4b liegt der Lichtstrom oder mit anderen Worten die Helligkeit der optoelektronischen Bauelemente zwischen 38 Lumen und 41 Lumen bei einem elektrischen Strom von 350 mA.

Figur 5c zeigt einen Teilbereich der Figur 4a. Es sind die gemessenen Farborte blau emittierender Halbleiterchips 103 bei einer Leuchtstoffkonzentration von 2% aufgetragen. Es sind die Flächen 2, 3, 4 der Blaunormen eingezeichnet. Es ist der gesamte Dominantwellenlängenbereich 25 der optoelektronischen Bauelemente bei 2% Leuchtstoffkonzentration, in Form eines Segments aufgetragen. Es sind die Farborte 26 für eine Chipwellenlänge von 441 nm, die Farborte 27 für eine Chipwellenlänge von 451 nm und die Farborte 28 für eine Chipwellenlänge von 454 nm aufgetragen. Der Dominantwellenlängenbereich der optoelektronischen Bauelemente liegt zwischen 469 nm und 471 nm. Gemäß Figur 4b liegt der Lichtstrom oder mit anderen Worten die Helligkeit der optoelektronischen Bauelemente zwischen 42 Lumen und 46 Lumen bei einem elektrischen Strom von 350 mA.

Das optoelektronische Bauelement wurde zur Veranschaulichung des zugrundeliegenden Gedankens anhand einiger Ausführungsbeispiele beschrieben. Die Ausführungsbeispiele sind dabei nicht auf bestimmte Merkmalskombinationen beschränkt. Auch wenn einige Merkmale und Ausgestaltungen nur im Zusammenhang mit einem besonderen Ausführungsbeispiel oder einzelnen Ausführungsbeispielen beschrieben wurden, können sie jeweils mit anderen Merkmalen aus anderen Ausführungsbeispielen kombiniert werden. Es ist ebenso denkbar, in Ausführungsbeispielen einzelne dargestellte Merkmale oder besondere Ausgestaltungen wegzulassen oder hinzuzufügen, soweit die allgemeine technische Lehre realisiert bleibt.

### Bezugszeichenliste

- 1000: optoelektronisches Bauelement
- 1: Farborte der Halbleiterchips im Referenzfall
- 2: Fläche der Blaunorm EN 129661 C1
- 3: Fläche der Blaunorm EN 129661 C2
- 4: Rus Rail
- 5: Einhüllende der Farborte bei 1% Leuchtstoff
- 6: Farborte bei Chipwellenlänge 441 nm, 1% Leuchtstoff
- 7: Farborte bei Chipwellenlänge 451 nm, 1% Leuchtstoff
- 8: Farborte bei Chipwellenlänge 454 nm, 1% Leuchtstoff
- 10: Farborte der LEDs gemäß der Simulation
- 15: Einhüllende der Farborte bei 1,5 % Leuchtstoff
- 16: Farborte bei Chipwellenlänge 441 nm, 1,5% Leuchtstoff
- 17: Farborte bei Chipwellenlänge 451 nm, 1,5% Leuchtstoff
- 18: Farborte bei Chipwellenlänge 454 nm, 1,5% Leuchtstoff
- 25: Einhüllende der Farborte bei 2 % Leuchtstoff
- 26: Farborte bei Chipwellenlänge 441 nm, 2% Leuchtstoff
- 27: Farborte bei Chipwellenlänge 451 nm, 2% Leuchtstoff
- 28: Farborte bei Chipwellenlänge 454 nm, 2% Leuchtstoff
- 40: Halbleiterchip mit Emissionswellenlänge im blauen Spektralbereich
- 41: Träger/Leadframe
- 42: Bonddraht
- 43: Verguss
- 44: Leuchtstoff
- 45: Austrittsfenster
- 46: projizierter Dominantwellenlängenbereich
- 100: Ausschnitt aus dem Farbraum gemäß CIE-Normfarbsystem
- 101: Farbort für Halbleiterchips bei Leuchtstoffkonzentration von 1%
- 102: Farbort für Halbleiterchips bei Leuchtstoffkonzentration von 1,5%
- 103: Farbort für Halbleiterchips bei Leuchtstoffkonzentration von 2%
- 110: Farbort eines Halbleiterchips mit Dominantwellenlänge 441 nm
- 111: Farbort eines Halbleiterchips mit Dominantwellenlänge 451 nm
- 112: Farbort eines Halbleiterchips mit Dominantwellenlänge 454 nm
- 113: Farbort eines Halbleiterchips mit Dominantwellenlänge 465,5 nm

## Patentansprüche

1. Optoelektronisches Bauelement (1000) mit:
einem Halbleiterchip (40) und
einem den Halbleiterchip (40) zumindest teilweise umgebenden Leuchtstoff (44),
wobei der Halbleiterchip (40) eine Primärstrahlung im kurzwelligen blauen Spektralbereich bei einer Dominantwellenlänge von kleiner etwa 465 nm emittiert und
wobei der Leuchtstoff (44) zumindest einen Teil der Primärstrahlung in eine längerwellige Sekundärstrahlung im grünen Spektralbereich bei einer Dominantwellenlänge zwischen etwa 490 nm und etwa 550 nm wandelt und
wobei ein Mischlicht aus Primärstrahlung und Sekundärstrahlung eine Dominantwellenlänge bei Wellenlängen zwischen etwa 460 nm und etwa 480 nm aufweist, so dass der Lichtstrom des Mischlichts um bis zu 130 % größer ist als der Lichtstrom bei einem optoelektronischen Bauelement ohne Leuchtstoff (44) mit gleicher Dominantwellenlänge im Bereich zwischen 460 nm und 480 nm, wobei der Leuchtstoff (44) in Form von Partikeln in einem Verguss (43) in einer Konzentration kleiner 3 Gewichtsprozent verteilt ist.

2. Optoelektronisches Bauelement gemäß Anspruch 1, wobei die Farborte des Mischlichts aus der vom Halbleiterchip (40) emittierten Primärstrahlung mit einer Dominantwellenlänge im Bereich von etwa 440 nm bis etwa 455 nm und aus vom Leuchtstoff (44) ausgehenden Sekundärstrahlung mit einer Dominantwellenlänge im Bereich von etwa 490 nm bis etwa 550 nm im CIE-Diagramm (100) so nahe beieinander liegen, dass bei einheitlicher Leuchtstoffkonzentration die Dominantwellenlängen des Mischlichts innerhalb eines Wellenlängenbereichs von etwa 2 bis 4 nm, insbesondere 3 nm, liegen.

3. Optoelektronisches Bauelement gemäß Anspruch 2, wobei der Farbort des optoelektronischen Bauelements (1000), das Mischlicht emittiert, im CIE-Diagramm auf den durch die verschiedenen Blaunormen, insbesondere EN 12966 C1 (VMS) und EN 12966 C2 (VMS), aufgespannten Flächen liegt.

4. Optoelektronisches Bauelement gemäß einem der vorigen Ansprüche, wobei der Leuchtstoff (44) im Verguss (43) in einer Konzentration kleiner 1,5 Gewichtsprozent vorliegt.

5. Optoelektronisches Bauelement gemäß einem der vorigen Ansprüche, wobei der Leuchtstoff (44) ein Europium aktiviertes Blau-Grünes Silikat, insbesondere ein Chlorosilikat mit der Summenformel Ca_{8-x-y}EuₓMn_{y}Mg(SiO₄)₄Cl₂, aufweist, wobei y≥0,03 ist und der Anteil an Europium zwischen x=0,005 und x=1,5 liegt.

6. Optoelektronisches Bauelement gemäß einem der vorigen Ansprüche, wobei der Leuchtstoff (44) Europium aktivierte Orthosilicate mit der Summenformel (Ca,Sr,Ba)₂SiO₄:EU aufweist.

7. Optoelektronisches Bauelement gemäß einem der vorigen Ansprüche, wobei der Leuchtstoff (44) Europium aktivierte Thiogallate mit der Summenformel (Mg,Ca,Sr,Ba)Ga₂S₄:EU aufweist.

8. Optoelektronisches Bauelement gemäß einem der vorigen Ansprüche, wobei der Leuchtstoff (44) Europium aktivierte Si-ONe mit der Summenformel Ba₃Si₆O₁₂N₂:EU aufweist.

9. Optoelektronisches Bauelement gemäß einem der vorigen Ansprüche, wobei der Leuchtstoff (44) beta-SiAlON aufweist.

10. Optoelektronisches Bauelement gemäß einem der vorigen Ansprüche, wobei der Leuchtstoff (44) eine Quanteneffizienz von bis zu 70% aufweist.

## Claims

1. Optoelectronic component (1000) comprising:
a semiconductor chip (40) and
a phosphor (44) at least partly surrounding the semiconductor chip (40),
wherein the semiconductor chip (40) emits a primary radiation in the short-wave blue spectral range at a dominant wavelength of less than approximately 465 nm, and
wherein the phosphor (44) converts at least part of the primary radiation into a longer-wave secondary radiation in the green spectral range at a dominant wavelength of between approximately 490 nm and approximately 550 nm, and
wherein a mixed light composed of primary radiation and secondary radiation has a dominant wavelength at wavelengths of between approximately 460 nm and approximately 480 nm, such that the luminous flux of the mixed light is up to 130% greater than the luminous flux in the case of an optoelectronic component without a phosphor (44) having an identical dominant wavelength in the range of between 460 nm and 480 nm, wherein the phosphor (44) is distributed in the form of particles in a potting (43) in a concentration of less than 3 per cent by weight.

2. Optoelectronic component according to Claim 1, wherein the colour loci of the mixed light composed of the primary radiation emitted by the semiconductor chip (40) and having a dominant wavelength in the range of approximately 440 nm to approximately 455 nm and composed of secondary radiation emerging from the phosphor (44) and having a dominant wavelength in the range of approximately 490 nm to approximately 550 nm in the CIE diagram (100) are so close to one another that in the case of uniform phosphor concentration the dominant wavelengths of the mixed light lie within a wavelength range of approximately 2 to 4 nm, in particular 3 nm.

3. Optoelectronic component according to Claim 2, wherein the colour locus of the optoelectronic component (1000), which emits mixed light, in the CIE diagram lies on the areas spanned by the various blue standards, in particular EN 12966 C1 (VMS) and EN 12966 C2 (VMS).

4. Optoelectronic component according to any of the preceding claims, wherein the phosphor (44) is present in the potting (43) in a concentration of less than 1.5 per cent by weight.

5. Optoelectronic component according to any of the preceding claims, wherein the phosphor (44) comprises a europium-activated blue-green silicate, in particular a chlorosilicate having the empirical formula Ca_{8-x-y}EuₓMn_{y}Mg (SiO₄)₄Cl₂, wherein y≥0.03 and the part of Europium lies between x=0.005 and x=1.5.

6. Optoelectronic component according to any of the preceding claims, wherein the phosphor (44) comprises europium-activated orthosilicates having the empirical formula (Ca, Sr, Ba)₂SiO₄:EU.

7. Optoelectronic component according to any of the preceding claims, wherein the phosphor (44) comprises europium-activated thiogallates having the empirical formula (Mg, Ca, Sr, Ba)Ga₂S₄:EU.

8. Optoelectronic component according to any of the preceding claims, wherein the phosphor (44) comprises europium-activated SiONs having the empirical formula Ba₃Si₆O₁₂N₂:EU.

9. Optoelectronic component according to any of the preceding claims, wherein the phosphor (44) comprises beta-SiAlON.

10. Optoelectronic component according to any of the preceding claims, wherein the phosphor (44) has a quantum efficiency of up to 70%.

## Revendications

1. Composant optoélectronique (1000) présentant :
une puce semi-conductrice (40) et
une matière luminescente (44) qui entoure au moins une partie de la puce semi-conductrice (40),
la puce semi-conductrice (40) émettant un rayonnement primaire dans la plage spectrale bleue des courtes longueurs d'onde, avec une longueur d'onde dominante inférieure à environ 465 nm et
la matière luminescente (44) convertissant au moins une partie du rayonnement primaire en un rayonnement secondaire de plus grande longueur d'onde dans la plage spectrale du vert, avec une longueur d'onde dominante comprise entre environ 490 nm et environ 550 nm et
une lumière mélangée constituée du rayonnement primaire et du rayonnement secondaire présentant une longueur d'onde dominante à des longueurs d'onde comprises entre environ 460 nm et environ 480 nm, de sorte que le flux de lumière mélangée soit de jusque 130 % plus élevé que le flux lumineux d'un composant optoélectronique sans matière luminescente (44) pour une même longueur d'onde dominante dans la plage de 460 nm à 480 nm, la matière luminescente (44) étant répartie sous la forme de particules dans une pâte de coulée (43) à une concentration inférieure à 3 pour cent en poids.

2. Composant optoélectronique selon la revendication 1, dans lequel dans la lumière mélangée, le rayonnement primaire émis par la puce semi-conductrice (40), d'une longueur d'onde dominante de l'ordre d'environ 440 nm à environ 455 nm, et le rayonnement secondaire émis par la substance luminescente (44) et dont la longueur d'onde dominante est de l'ordre d'environ 490 nm à environ 550 nm sont situés dans les diagrammes CIE (100) à proximité mutuelle suffisante que pour une concentration unitaire en substance luminescente, les longueurs d'onde dominantes de la lumière mélangée soient situées à l'intérieur d'une plage de longueurs d'onde d'environ 2 à 4 nm et en particulier de 3 nm.

3. Composant optoélectronique selon la revendication 2, dans lequel la couleur du composant optoélectronique (1000) qui émet la lumière mélangée est située dans le diagramme CIE sur la surface sous-tendue par les différents bleus normés, notamment EN 12966 C1 (VMS) et EN 12966 C2 (VMS).

4. Composant optoélectronique selon l'une des revendications précédentes, dans lequel la substance luminescente (44) est présente dans la pâte de coulée (43) à une concentration inférieure à 1,5 pour cent en poids.

5. Composant optoélectronique selon l'une des revendications précédentes, dans lequel la substance luminescente (44) présente un silicate bleu-vert activé par Europium, en particulier en chlorosilicate dont la formule globale est Ca_{8-x-y}EuₓMn_{y}Mg (SiO₄)₄Cl₂, avec y≥0,03 et la part d'europium est entre x=0,005 et x=1, 5.

6. Composant optoélectronique selon l'une des revendications précédentes, dans lequel la substance luminescente (44) présente un orthosilicate activé par Europium dont la formule globale est (Ca,Sr,Ba)₂SiO₄:EU.

7. Composant optoélectronique selon l'une des revendications précédentes, dans lequel la substance luminescente (44) présente un thiogallate activé par Europium de formule globale (Mg,Ca,Sr,Ba)Ga₂S₄:EU.

8. Composant optoélectronique selon l'une des revendications précédentes, dans lequel la substance luminescente (44) présente un Si-ONe de formule globale Ba₃Si₆O₁₂N₂:EU

9. Composant optoélectronique selon l'une des revendications précédentes, dans lequel la substance luminescente (44) présente du beta-SiALON.

10. Composant optoélectronique selon l'une des revendications précédentes, dans lequel la substance luminescente (44) présente un rendement quantique pouvant atteindre 70 %.
